# EUROPÄISCHE PATENTANMELDUNG

(11) **EP 3 611 766 A1**
(43) Veröffentlichungstag der Anmeldung: **19.02.2020**
(21) Anmeldenummer: 19000439.0
(22) Anmeldetag: 10.11.2017
(51) Int. Cl.: H01L 29/861, H01L 21/329, H01L 29/207, H01L 29/36, H01L 21/18, H01L 29/06

(54) **III-V-HALBLEITERDIODE**

(30) Priorität: 14.11.2016 DE 102016013541
(62) Teilanmeldung aus: 17001843.6
(71) Anmelder: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(57) **Zusammenfassung**

Stapelförmige III-V-Halbleiterdiode (10) aufweisend ein p⁺-Substrat (12) mit einer Dotierstoffkonzentration von 5^{∗}10¹⁸-5^{∗}10²⁰cm⁻³, einer Schichtdicke (Dₛ) von 50-500 µm und umfassend eine GaAs-Verbindung, eine n⁻-Schicht (16) mit einer Dotierstoffkonzentration von 10¹⁴-10¹⁶ cm⁻³, einer Schichtdicke (D₁) von 10-300 µm und umfassend eine GaAs-Verbindung, eine n⁺-Schicht (18) mit einer Dotierstoffkonzentration von mindestens 10¹⁹cm⁻³, einer Schichtdicke (D₂) kleiner 2 µm und umfassend eine GaAs-Verbindung, wobei die n⁻Schicht (16) und die n⁺-Schicht (18) stoffschlüssig miteinander verbunden sind, zwischen dem p⁺-Substrat (12) und der n⁻-Schicht (16) eine dotierte Zwischenschicht (14) mit einer Schichtdicke (Dₚ) von 5-50 µm und einer Dotierstoffkonzentration von 10¹⁵-10¹⁷ cm⁻³ angeordnet ist und die Zwischenschicht (14) mit dem p⁺-Substrat (12) und mit der n⁻-Schicht (16) stoffschlüssig verbunden ist.

## Beschreibung

Die Erfindung betrifft eine III-V-Halbleiterdiode.

Aus "GaAs Power Devices" von German Ashkinazi, ISBN 965-7094-19-4, Seite 8 und 9 ist eine hochspannungsfeste Halbleiterdiode p⁺ - n - n⁺ bekannt.

Vor diesem Hintergrund besteht die Aufgabe der Erfindung darin, eine Vorrichtung anzugeben, die den Stand der Technik weiterbildet.

Die Aufgabe wird durch eine III-V-Halbleiterdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige III-V-Halbleiterdiode bereitgestellt, aufweisend ein p⁺-Substrat mit einer Dotierstoffkonzentration von 5^{∗}10¹⁸-5^{∗}10²⁰cm⁻³ und einer Schichtdicke zwischen 50 µm und 500 pm, wobei das p⁺-Substrat eine GaAs-Verbindung umfasst oder aus einer GaAs-Verbindung besteht.

Ferner weist die III-V-Halbleiterdiode eine n⁻-Schicht mit einer Dotierstoffkonzentration von 10¹⁴-10¹⁶ cm⁻³ und einer Schichtdicke von 10-300 µm sowie eine n⁺-Schicht mit einer Dotierstoffkonzentration von mindestens 5^{∗}10¹⁹cm⁻³ und einer Schichtdicke kleiner 30 µm auf, wobei die n⁻-Schicht und die n⁺-Schicht jeweils eine GaAs-Verbindung umfassen oder jeweils aus einer GaAs-Verbindung bestehen und stoffschlüssig miteinander verbunden sind.

Zwischen dem p⁺-Substrat und der n⁻-Schicht ist eine dotierte Zwischenschicht mit einer Schichtdicke von 1-50 µm und einer Dotierstoffkonzentration von 10¹²-10¹⁷ cm⁻³ angeordnet, wobei die Zwischenschicht mit dem p⁺-Substrat und mit der n⁻-Schicht stoffschlüssig verbunden ist.

Es versteht sich, dass die Zwischenschicht eine im Vergleich zu den stoffschlüssig verbundenen Schichten wenigstens eine unterschiedliche Dotierstoffkonzentration aufweist.

Ein Vorteil ist, dass sich mit der erfindungsgemäßen III-V-Halbleiterdiode auf einfache Weise Sperrspannungen in einem Bereich von 200V - 3,300 V mit kleineren Einschaltwiderständen und geringeren Kapazitäten pro Fläche als herkömmliche hochsperrende Dioden aus Si oder aus SiC herstellen lassen. Hierdurch sind Schaltfrequenzen von 30 kHz bis zu 0,5 GHz und Stromdichten von 0.5 A/mm² bis 5 A/mm² erreichbar.

Ein weiterer Vorteil ist, dass sich die III-V-Halbleiterdioden kostengünstiger als vergleichbare hochsperrende Dioden aus SiC herstellen lassen.

Insbesondere lassen sich die erfindungsgemäßen III-V-Halbleiterdioden als Freilaufdioden verwenden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten.

In einer ersten Ausführungsform ist die Zwischenschicht p-dotiert ausgebildet und umfasst gemäß alternativer Weiterbildungen als Dotierstoffe Zink und / oder Silizium. Die Dotierstoffkonzentration der Zwischenschicht ist kleiner als die Dotierstoffkonzentration des p+-Substrats. Vorzugsweise ist die Dotierstoffkonzentration in einem Bereich zwischen einem Faktor 2 bis zu einem Faktor 100.000, d.h. fünf Größenordnungen kleiner.

In einer anderen Ausführungsform ist die Zwischenschicht n-dotiert ausgebildet und umfasst als Dotierstoff vorzugsweise Silizium. Die Dotierstoffkonzentration der Zwischenschicht ist kleiner als die Dotierstoffkonzentration des n⁻-Bereiches. Vorzugsweise ist die Dotierstoffkonzentration in einem Bereich bis zu einem Faktor 100 kleiner.

In einer anderen Ausführungsform umfasst das p⁺-Substrat als Dotierstoff Zink. Die n⁻-Schicht und/oder die n⁺-Schicht umfassen in einer weiteren Ausführungsform vorzugsweise Silizium und / oder Chrom und / oder Palladium und / oder Zinn.

In einer weiteren Ausführungsform ist der stapelförmige Schichtaufbau bestehend aus dem p⁺-Substrat, der Zwischenschicht, der n'-Schicht und der n⁺-Schicht monolithisch ausgebildet.

In einer weiteren Ausführungsform beträgt eine Gesamthöhe des stapeiförmigen Schichtaufbaus bestehend aus dem p⁺-Substrat, der Zwischenschicht, der n⁻-Schicht und der n⁺-Schicht höchstens 150-500 µm.

Vorzugsweise ist eine Oberfläche des Schichtaufbaus viereckig, insbesondere rechteckig oder quadratisch und mit einer Kantenlänge in einem Bereich zwischen 1 mm und 20 mm ausgebildet. In einer Weiterbildung weisen die viereckigen Strukturen jeweils abgerundete Kanten und / oder Ecken auf, um Feldstärkespitzen insbesondere bei Spannungen oberhalb 500 V zu vermeiden.

In einer anderen Ausführungsform ist die Oberfläche rund ausgeführt. Hierdurch werden Überhöhungen der Feldstärke besonders effektiv reduziert. Vorzugsweise ist die Oberfläche kreisförmig oder oval ausgeführt.

In einer weiteren Ausführungsform weist der stapelförmige Schichtaufbau bestehend aus dem p⁺-Substrat, der Zwischenschicht, der n⁻-Schicht und der n⁺-Schicht ein zwischen der n⁻-Schicht und der Zwischenschicht ausgebildeter Halbleiterbond auf. Es wird angemerkt, dass der Ausdruck Halbleiterbond synonym mit dem Ausdruck Waferbond verwendet wird. Der Schichtaufbau bestehend aus einem p⁺-Substrat und der Zwischenschicht und bildet einen ersten Teilstapel und der Schichtaufbau bestehend aus der n⁺-Schicht und einer n⁻-Schicht bildet einen zweiten Teilstapel. Der erste Teilstapel und der zweite Teilstapel sind jeweils monolithisch ausgebildet.

In einer Weiterbildung wird der erste Teilstapel gebildet, in dem ausgehend von einem p⁺-Substrat mittels Epitaxie die Zwischenschicht hergestellt wird oder angeordnet ist. Vorzugsweise weist die als p⁻-Schicht ausgebildete Zwischenschicht eine Dotierung kleiner als 10¹³ N/cm⁻³ oder eine Dotierung zwischen 10¹³ N/cm⁻³ und 10¹⁵ N/cm⁻³ auf. In einer Ausführungsform wird das p⁺-Substrat vor oder nach dem Bonden durch einen Schleifprozess auf eine Dicke zwischen 200 µm und 500 µm gedünnt.

In einer Ausführungsform Ist ein erster Teilstapel vorgesehen, in dem ausgehend von einem p⁺-Substrat mittels Epitaxie die Zwischenschicht angeordnet ist und des Weiteren ist ein zweiter Stapel vorgesehen, in dem ausgehend von einem n⁻-Substrat, das n⁻-Substrat mit dem zweiten Stapel durch einen Waferbondprozess verbunden ist.

In einer anderen Ausführungsform wird der zweite Stapel gebildet, in dem ausgehend von einem n⁻-Substrat, das n⁻-Substrat mit dem zweiten Stapel durch einen Waferbondprozess verbunden wird oder ist. In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm. Vorzugsweise liegt die Dotierung des n⁻-Substrats in einem Bereich zwischen 10¹³ N/cm⁻³ und 10¹⁵ N/cm⁻³. Ein Vorteil des Waferbonden ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler verringern.

In einer alternativen Ausführungsform weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einer Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5x10¹⁹ N/cm⁻³ erzeugt. Das Dünnen des n⁻-Substrats erfolgt vorzugsweise mittels eines CMP Schrittes, d.h. mittels chemischen mechanischen Polierens.

In einer anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Vorderseite abgelöst.

In einer Ausführungsform werden die Oberfläche des n⁺-Substrats und die Oberfläche des p⁺-Substrats metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p+-Schicht ausgebildet.

Untersuchungen haben gezeigt, dass sich mit bestimmten Kombinationen von einer p⁻- Zwischenschicht und n⁻-Schicht verschiedene Sperrspannungen erzielen lassen.
In einer ersten Variante umfasst die:
p⁻-Zwischenschicht eine Dicke zwischen 10 µm bis 25 µm und für die n⁻-Schicht eine Dicke zwischen 40 µm und 90 µm eine Sperrspannung von ca. 900 V ergibt.

In einer zweiten Variante umfasst die:
p⁻-Zwischenschicht eine Dicke zwischen 25 µm bis 25 µm und für die n⁻-Schicht eine Dicke zwischen 40 µm und 70 µm eine Sperrspannung von ca. 1200 V ergibt.

In einer dritten Variante umfasst die:
p⁻-Zwischenschicht eine Dicke zwischen 35 µm bis 50 µm und für die n⁻-Schicht eine Dicke zwischen 70µm und 150 µm und 70 µm eine Sperrspannung von ca. 1500 V ergibt.

Die Dioden in der ersten bis dritten Variante lassen sich hinsichtlich der Ausbildung der Raumladungszonen auch als Punsch- Dioden bezeichnen.
In einer vierten Variante umfasst die:
p⁻-Zwischenschicht eine Dicke zwischen 10 µm bis 25 µm und für die n⁻-Schicht eine Dicke zwischen 60 µm und 110 µm.

In einer fünften Variante umfasst die:
p⁻-Zwischenschicht eine Dicke zwischen 10 µm bis 25 µm und für die n⁻-Schicht eine Dicke zwischen 70 µm und 140.

In einer sechsten Variante umfasst die:
p⁻-Zwischenschicht eine Dicke zwischen 35 µm bis 50 µm und für die n⁻-Schicht eine Dicke zwischen 80µm und 200 µm.

Die Dioden in der vierten bis sechsten Variante lassen sich hinsichtlich der Ausbildung der Raumladungszonen auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine Ansicht auf eine erste erfindungsgemäße Ausführungsform eine III-V-Halbleiterdiode,
- Figur 2: eine Ansicht auf eine erste erfindungsgemäße Ausführungsform einer Schichtenfolge
- Figur 3: eine Ansicht auf eine zweite erfindungsgemäße Ausführungsform einer Schichtenfolge,
- Figur 4: eine Aufsicht auf die III-V-Halbleiterdiode aus Figur 1.

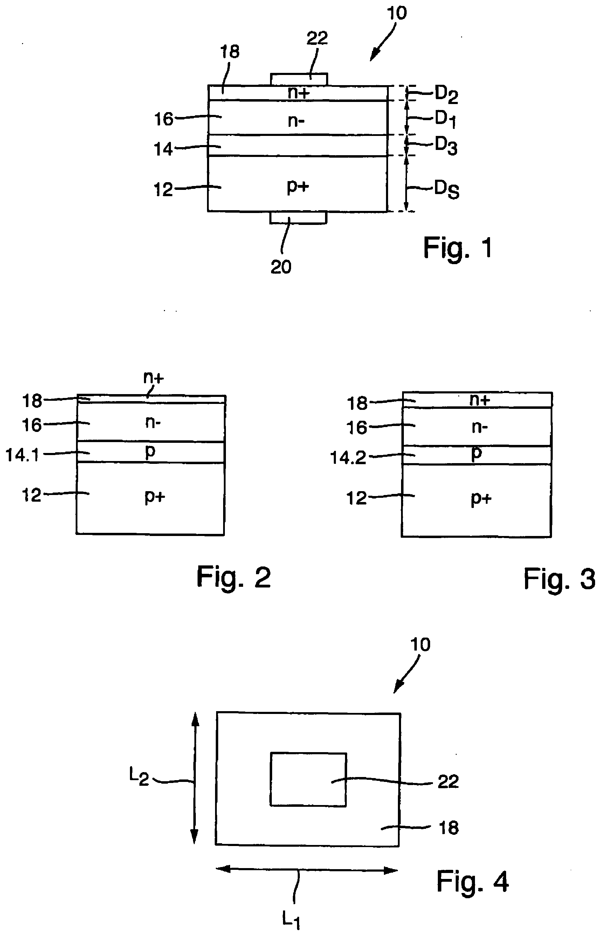

Die Abbildung der Figur 1 zeigt eine Ansicht einer ersten Ausführungsform einer erfindungsgemäßen stapelförmige III-V-Halbleiterdiode 10, aufweisend ein p⁺-Substrat 12, eine mit dem p⁺-Substrat 12 stoffschlüssig verbundene Zwischenschicht 14, eine mit der Zwischenschicht 14 stoffschlüssig verbundene n⁻-Schicht 16, eine mit der n⁻-Schicht 16 stoffschlüssig verbundene n⁺-Schicht 18, sowie einen ersten Kontakt 20 und einen zweiten Kontakt 22. Der erste Kontakt 20 ist stoffschlüssig mit einer Unterseite des p⁺-Substrats 12 verbunden, während der zweite Kontakt 22 stoffschlüssig mit einer Oberseite der n⁺-Schicht 18 verbunden ist.

Das p⁺-Substrat 12 umfasst eine GaAs-Verbindung, ist p-dotiert, weist eine Dotierstoffkonzentration von 10¹⁹ cm⁻³. Eine Schichtdicke Dₛ des p⁺-Substrats 12 liegt zwischen 50 µm und 500 µm.

Die Zwischenschicht 14 weist eine Schichtdicke D₃ von 1 - 50 µm und eine Dotierung mit einer Dotierstoffkonzentration von 10¹²-10¹⁷ cm⁻³ auf.

Die n⁻-Schicht 16 ist schwach n-dotiert mit einer Dotierstoffkonzentration von 10¹²-10¹⁶ cm⁻³ und weist eine Schichtdicke D₁ von 10-300 µm auf.

Die n⁺-Schicht 18 ist stark n-dotiert mit einer Dotierstoffkonzentration von mindestens 10¹⁹ cm⁻³ und einer Schichtdicke D₂ kleiner als 30 µm.

In den Abbildungen der Figuren 2 und 3 sind zwei alternative Ausführungsformen einer aus dem p⁺-Substrat 12, der n⁻-Schicht 16, der Zwischenschicht 14 und der n⁺-Schicht 18 bestehenden Schichtaufbaus 100 einer erfindungsgemäßen III-V-Halbleiterdiode dargestellt. Im Folgenden werden nur die Unterschiede zu der Abbildung der Figur 1 erläutert.

Der Schichtaufbau 100 kann in einer ersten Ausführungsform eine niedrig p-dotierte Zwischenschicht 14.1 aufweisen, wie in Figur 2 dargestellt. Alternativ weist die Schichtenfolge eine niedrig n-dotierte Zwischenschicht 14.2 auf, wie in Figur 3 dargestellt.

In der Abbildung der Figuren 4 ist eine Aufsicht auf die in Figur 1 gezeigte erste Ausführungsform einer erfindungsgemäßen III-V-Halbleiterdiode dargestellt. Im Folgenden werden nur die Unterschiede zu der Abbildung der Figur 1 erläutert.

Der stapelförmige Schichtaufbau 100 der III-V-Halbleiterdiode 10 bestehend aus dem p⁺-Substrat 12, der n⁻-Schicht 16, der Zwischenschicht 14 und der n⁺-Schicht 18 weist einen rechteckigen Umfang und hierdurch auch eine rechteckige Oberfläche mit den Kantenlängen L1 und L2 auf. Die auf der Oberfläche der Schichtenfolge 100 angeordnete Kontaktfläche 22 überdeckt nur einen Tell der Oberfläche.

Es versteht sich, dass in einer nicht dargestellten Ausführungsform weist der der Stapel auch viereckig Oberfläche auf. Insbesondere ist die Oberfläche quadratisch ausgeführt.

In einer anderen nicht dargestellten Ausführungsform sind bei den eckigen Ausführungen die Ecken verrundet, um Feldstärkespitzen bei hohen Spannungen zu vermeiden.

In einer anderen nicht dargestellten Ausführungsform ist die Oberfläche rund ausgeführt. Hierdurch werden Überhöhungen der Feldstärke besonders effektiv reduziert. Vorzugsweise ist die Oberfläche kreisförmig oder oval ausgeführt.

## Patentansprüche

1. Stapelförmige III-V-Halbleiterdlode (10) aufweisend,
- ein p⁺-Substrat (12) mit einer Dotierstoffkonzentration von 5^{∗}10¹⁸-5^{∗}10²⁰cm⁻³, einer Schichtdicke (Dₛ) von 50-500 µm, wobei das p⁺-Substrat (12) eine GaAs-Verbindung umfasst oder aus einer GaAs Verbindung besteht,
- eine n⁻-Schicht (16) mit einer Dotierstoffkonzentration von 10¹²-10¹⁶ cm⁻³, einer Schichtdicke (D₁) von 10-300 µm und eine GaAs-Verbindung umfasst oder aus einer GaAs Verbindung besteht,
- wobei die n⁻-Schicht (16) und die n⁺-Schicht (18) stoffschlüssig miteinander verbunden sind,
**dadurch gekennzeichnet, dass**
- eine n⁺-Schicht (18) mit einer Dotierstoffkonzentration von mindestens 10¹⁹ cm⁻³, einer Schichtdicke (D₂) kleiner 30 µm und eine GaAs-Verbindung umfasst oder aus einer GaAs Verbindung besteht,
- zwischen dem p⁺-Substrat (12) und der n⁻-Schicht (16) eine dotierte Zwischenschicht (14) mit einer Schichtdicke (D₃) von 1 µm -50 µm und einer Dotierstoffkonzentration von 10¹²-10¹⁷ cm⁻³ angeordnet ist,
- die Zwischenschicht (14) p-dotiert ausgebildet ist,
- wobei die Zwischenschicht (14) mit dem p⁺-Substrat (12) und mit der n⁻Schicht (16) stoffschlüssig verbunden ist.

2. III-V-Halbleiterdiode (10) nach Anspruch 1, **dadurch gekennzeichnet, dass** die Dotierstoffkonzentration der Zwischenschicht (14) in einem Bereich zwischen einem Faktor 2 bis zu einem Faktor von fünf Größenordnungen kleiner ist als die Dotierstoffkonzentration des p⁺-Substrats.

3. III-V-Halbleiterdiode (10) nach Anspruch 1 oder 2, **dadurch gekennzeichnet, dass** die Zwischenschicht (14) Zink oder Silizium als Dotierstoff umfasst.

4. III-V-Halbleiterdiode (10) nach einem der Ansprüche 1 bis 3, **dadurch gekennzeichnet, dass** das p⁺-Substrat (12) Zink als Dotierstoff umfasst.

5. III-V-Halbleiterdiode (10) nach einem der Ansprüche 1 bis 4, **dadurch gekennzeichnet, dass** die n⁻-Schicht (16) und/oder die n⁺-Schicht Silizium und/oder Chrom und/oder Palladium und/oder Zinn als Dotierstoff umfassen.

6. III-V-Halbleiterdiode (10) nach einem der Ansprüche 1 bis 9, **dadurch gekennzeichnet, dass** der stapelförmige Schichtaufbau (100) bestehend aus dem p⁺-Substrat (12), der n⁻-Schicht (16), der Zwischenschicht (14) und der n⁺-Schicht (18) monolithisch ausgebildet ist.

7. III-V-Halbleiterdiode (10) nach einem der Ansprüche 1 bis 6, **dadurch gekennzeichnet, dass** eine Gesamthöhe des stapelförmigen Schichtaufbaus (100) bestehend aus dem p⁺-Substrat (12), der n⁻-Schicht (16), der Zwischenschicht (14) und der n⁺-Schicht (18) höchstens 150-500 µm beträgt.

8. III-V- Halbleiterdiode nach einem der Ansprüche 1 bis 7, **dadurch gekennzeichnet, dass** der stapelförmige Schichtaufbau (100) bestehend aus dem p⁺-Substrat (12), der n⁻-Schicht (16), der Zwischenschicht (14) und der n⁺-Schicht (18) eine rechteckige oder quadratische Oberfläche mit Kantenlängen (L1, L2) zwischen 1 mm und 10 mm aufweist.

9. III-V-Halbleiterdiode nach einem der Ansprüche 1 bis 7, **dadurch gekennzeichnet, dass** der stapelförmige Schichtaufbau (100) bestehend aus dem p⁺-Substrat (12), der n⁻-Schicht (16), der Zwischenschicht (14) und der n⁺-Schicht (18) eine runde, vorzugsweise ovale oder kreisförmige Oberfläche aufweist.

10. III-V-Halbleiterdiode nach einem der Ansprüche 1 bis 19, **dadurch gekennzeichnet, dass** die Halbleiterdiode einen ersten Teilstapel und einen zweiten Teilstapel umfasst, wobei der erste Teilstapel ein p⁺-Substrat und eine epitaktisch auf dem p⁺-Substrat erzeugte Zwischenschicht aufweist, der zweite Teilstapel ein n⁻-Schicht und eine n⁺-Schicht aufweist und das n⁻-Substrat des zweiten Teilstapels durch einen Halbleiterbond mit der Zwischenschicht des ersten Teilstapels verbunden ist.
